# EUROPEAN PATENT SPECIFICATION

(11) **EP 2 863 426 B1**
(45) Date of publication and mention of the grant of the patent: **22.04.2020**
(21) Application number: 14814663.2
(22) Date of filing: 28.02.2014
(51) Int. Cl.: H01L 23/373, H01L 23/42, F28D 9/00

(54) **THERMAL INTERFACE SHEET, PREPARATION METHOD THEREFOR AND COOLING SYSTEM THEREFOR**
WÄRMESCHNITTSTELLENFOLIE, HERSTELLUNGSVERFAHREN DAFÜR UND KÜHLSYSTEM DAFÜR
FEUILLE D'INTERFACE THERMIQUE, SON PROCÉDÉ DE PRÉPARATION ET SYSTÈME DE REFROIDISSEMENT ASSOCIÉ

(30) Priority: 10.07.2013 CN 201310288650
(43) Date of publication of application: 22.04.2015
(73) Proprietor: Huawei Technologies Co., Ltd., Longgang District Shenzhen, Guangdong 518129 (CN)
(72) Inventor: XU, Yan, Shenzhen Guangdong 518129 (CN); ZHAO, Renzhe, Shenzhen Guangdong 518129 (CN); LI, Songlin, Shenzhen Guangdong 518129 (CN)
(74) Representative: Körber, Martin Hans
(86) International application number: PCT/CN2014/072666
(87) International publication number: WO 2015/003501

(56) References cited:
- CN-A- 101 248 154
- CN-A- 101 275 209
- CN-A- 101 372 614
- CN-A- 101 899 288
- US-A1- 2007 116 626
- US-A1- 2008 083 612
- US-A1- 2008 131 655
- US-A1- 2011 032 678
- US-A1- 2011 090 650
- THOSTENSON E T ET AL: "Advances in the science and technology of carbon nanotubes and their composites: a review", COMPOSITES SCIENCE AND TECHNOLOGY, LONDON, GB, vol. 61, no. 13, 1 October 2001 (2001-10-01), pages 1899-1912, XP002252197, DOI: 10.1016/S0266-3538(01)00094-X
- DAI H: "Carbon nanotubes: opportunities and challenges", SURFACE SCIENCE, NORTH-HOLLAND, vol. 500, no. 1-3, 10 March 2002 (2002-03-10), pages 218-241, XP004693300, ISSN: 0039-6028, DOI: 10.1016/S0039-6028(01)01558-8

## Description

### TECHNICAL FIELD

Embodiments of the present invention relate to a thermal interface pad and a heat dissipating system.

### BACKGROUND

Heat generated by heat emitting elements such as chips that work in electronic devices generally needs to be dissipated to the outside by using heat dissipating devices. From a microscopic perspective, much roughness exists on a contact interface between the heat emitting element and the heat dissipating device, and the contact interface between the heat emitting element and the heat dissipating device needs to be filled with thermal interface materials (Thermal Interface Materials, TIM) to reduce thermal contact resistance. With the miniaturization of electronic devices, light weight and high density become a trend in development.

Existing thermal interface materials, such as thermally conductive silicone grease and phase-change thermally conductive materials, generally have a thermal conductivity of no more than 6 W/mK, and therefore cannot meet heat dissipating requirements of high power density devices such as high-power field-effect transistors. For heat dissipation of this type of high power density device, a common process is to solder the high power density device and a heat dissipating component together by using tin-based solder, or an electrically and thermally conductive silver adhesive (Henkel CF3350) may also be used. The CF3350 electrically conductive silver adhesive has a thermal conductivity of approximately 7 W/mK, and a volume resistivity of approximately 2×10-⁴ Ω·cm, and may be classified as a thermally conductive adhesive of a high thermal conductivity. The electrically and thermally conductive silver adhesive may cause a short circuit in use due to overflow, is liable to corrosion or silver migration in an application environment, and has poor long-term reliability. The tin-based solder is generally a solder paste of Sn-Pb eutectic and lead-free SnAg-Cu alloys, which has high electrically- and thermally-conductive characteristics typical of metal alloys. However, high-cost metallization treatment by coating needs to be performed on the heat dissipating component to implement soldering, and a soldering process is completed by heating at a high temperature. A thermal interface pad according to the preamble of claim 1 is disclosed e.g. in related prior art technology is disclosed in US 2008/0131655 A1 and US 2008/0083612 A1. Further, related prior art technology is disclosed in US 2011/090650A1 and US 2011/032678 A1.

### SUMMARY

In view of this, embodiments of the present invention provide a thermal interface pad, which addresses a problem of a thermal interface material being unable to simultaneously satisfy requirements of high thermal conductivity and easy industrial mounting in the prior art.

According to a first aspect, an embodiment of the present invention provides a thermal interface pad, including a substrate and carbon nanowires. The substrate has a first surface and a second surface opposite to the first surface. The carbon nanowires are disposed on both the first surface and the second surface of the substrate, and the carbon nanowires are arranged in an array. The substrate is made from a solder alloy and has a thickness of 10 to 50 µm. The carbon nanowires disposed on the first surface of the substrate has a length of 0.5 to 10 µm, and the nano carbon material disposed on the second surface of the substrate has a length of 50 to 150 µm. A vapor deposited layer or a sputtered layer is further included, where the vapor deposited layer or the sputtered layer is located on one side of the second surface of the substrate. The carbon nanowires located on the second surface penetrate into the vapor deposited layer or the sputtered layer. At least a portion of the carbon nanowires on the second surface penetrates through the vapor deposited layer or the sputtered layer, and projects out of the vapor deposited layer or the sputtered layer. The portion of the carbon nanowires projecting out of the vapor deposited layer or the sputtered layer has a length of 0.5 to 10 µm.

Preferably, the carbon nanowires are perpendicular to at least one surface of the first surface and the second surface of the substrate.

Preferably, the carbon nanowires are at least one of carbon nanofibers and multi-walled carbon nanotubes.

Preferably, the carbon nanofibers have a diameter of 50 to 200 nm.

Preferably, the multi-walled carbon nanotubes have a diameter of 1 to 50 nm.

Preferably, the solder alloy is an indium-based alloy or a gallium-based alloy.

Preferably Further preferably, a total cross-sectional area of the carbon nanowires penetrating into the vapor deposited layer or the sputtered layer accounts for 50% to 99% of an area of the second surface of the substrate.

According to a second aspect, a heat dissipating system is provided, which includes a heat emitting element, a heat radiator, and a thermal pad interface according to the first aspect of the invention..

In conclusion, in the thermal interface pad provided in the embodiments of the present invention, a solder alloy is selected and used as a substrate, which has higher thermal conductivity compared with substrate materials such as thermally conductive silicone grease, phase-change materials, and polymers in the prior art. In addition, a nano carbon material is disposed on surfaces of the substrate provided in the embodiments of the present invention, and the nano carbon material may fill micropores microscopically existing in surfaces of a heat emitting component or a heat dissipating component, thereby significantly reducing thermal contact resistance. In addition, the thermal interface pad provided in the embodiments of the present invention has a substrate structure, may exist independently of the heat emitting element and a heat dissipating device, and may be attachable and affixed. Therefore, the thermal interface pad is easy for industrial production and use, thereby addressing a problem of a thermal interface pad being unable to simultaneously satisfy requirements of high thermal conductivity and easy industrial production and use in the prior art. The embodiments of the present invention further provide a heat dissipating system to which the thermal interface pad is applied, which not only improves a heat transfer effect of the heat emitting element, but also is convenient for mounting.

### BRIEF DESCRIPTION OF DRAWINGS

FIG. 1 is a side view of a thermal interface pad produced by using a production method according to an example FIG. 2 is a three-dimensional view of a part of a thermal interface pad produced by using a production method according to an example
FIG. 3 is a flowchart of a production method according to an embodiment of the present invention;
FIG. 4 is a side view of a thermal interface pad produced by using a production method according to an embodiment of the present invention;
FIG. 5 is an SEM (scanning electron microscope) image of a thermal interface pad produced by using a production method according to Example 1; and
FIG. 6 is a schematic diagram of a heat dissipating system according to an embodiment of the present invention.

### DESCRIPTION OF EMBODIMENTS

The following descriptions are exemplary implementation manners of the present invention. It should be noted that a person of ordinary skill in the art may make some improvements and polishing without departing from the principle of the present invention and the improvements and polishing shall also fall within the protection scope of the present invention.

A first aspect of embodiments of the present invention provides a thermal interface pad, which has high thermal conductivity, may be attachable and affixed, and is easy for industrial production and use.

According to the first aspect, an embodiment of the present invention provides a thermal interface pad, which includes a substrate and a nano carbon material. The substrate has a first surface and a second surface opposite to the first surface. The nano carbon material is disposed on both the first surface and the second surface of the substrate, and the nano carbon material is carbon nanowires arranged in an array. The substrate is one of a flexible composite metal film, flexible graphite and a solder alloy, and the flexible composite metal film is a flexible metal film with a surface coated with nickel, silver or gold.

In an example not covered by the present invention, the nano carbon material is disposed on both sides of the substrate of the thermal interface pad. The nano carbon material may fill micropores (generally represented by roughness, on a micron scale) existing in a surface of a heat emitting component or a surface of a heat dissipating component, thereby significantly reducing thermal contact resistance. The carbon nanowires are perpendicular to at least one surface of the first surface and the second surface of the substrate. The carbon nanowires are at least one of carbon nanofibers and multiwalled carbon nanotubes. Ordered arrangement of the carbon nanofibers enables the carbon nanofibers to have a uniform and better thermal conductivity in a thickness direction. A size of a diameter of the nano carbon material is related to a size of a catalyst particle used in a production process. Preferably, the nano carbon material has a diameter of ≤200 nm. Preferably, the carbon nanofibers have a diameter of 50 to 200 nm. Preferably, the multi-walled carbon nanotubes have a diameter of 1 to 50 nm. Theoretically, the carbon nanofibers can have a thermal conductivity in an axial direction (Z direction) of 2000 w/(m·k), and an electrical resistivity of 5×10⁻⁵ ohmcm.

In an example not covered by the present invention, a flexible composite metal film may be selected and used as the substrate. The flexible composite metal film is a flexible metal film having a metal such as nickel, silver or gold coated on a surface thereof as a barrier layer. The flexible metal film may be better adapted to an assembly gap between the heat emitting component and the heat dissipating component, and the flexible metal film has higher thermal conductivity than a polymer material used in the prior art. Preferably, the flexible metal film is one of copper foil, aluminum foil, nickel foil, a copper alloy sheet, and a stainless steel sheet. The flexible metal film having no barrier layer coated is chemically reactive at a high temperature, and tends to react with a catalyst when directly used for growing carbon nanofibers by means of chemical vapor deposition, which affects the growth of the carbon nanofibers. In the prior art, an aluminum oxide is generally disposed as a barrier layer between the flexible metal film and the catalyst; however, due to poor thermal or electrical conductivity, the aluminum oxide is unsuitable for production of the thermal interface pad. In this example, a metal material of low reactivity such as nickel, silver or gold used as the barrier layer has high thermal and electrical conductivity. The flexible composite metal film has a thickness of 10 to 200 µm. More preferably, the flexible composite metal film has a thickness of 10 to 50 µm.

Considering the fact that a height of the nano carbon material affects the thermal conductivity of the thermal interface pad, and that the height of the nano carbon material should be greater than flatness of an assembly face of the surface of the heat emitting component and the surface of the heat dissipating component, in this embodiment of the present invention, the nano carbon material disposed on at least one surface of the first surface and the second surface of the substrate has a length of 20 to 125 µm. The nano carbon material may tilt somewhat under assembly pressure, thereby compensating for assembly tolerance to some degree. More preferably, the nano carbon material disposed on the at least one surface of the first surface and the second surface of the substrate has a length of 25 to 60 µm. Further preferably, a total height of the substrate and the nano carbon material disposed on the first surface and the second surface of the substrate ranges from 100 µm to 200 µm, and more preferably, the total height of the substrate and the nano carbon material disposed on the first surface and the second surface of the substrate ranges from 100 µm to 150 µm.

In an example not covered by the present invention, flexible graphite may be selected and used as the substrate. The flexible graphite is highly oriented pyrolytic graphite. In this case, for a thickness of each structure, reference may be made to the foregoing case in which the flexible composite metal film is selected and used as the substrate. The flexible graphite has a thickness of 10 to 200 µm. The nano carbon material disposed on one or more of the first surface and the second surface of the substrate has a height of 20 to 125 µm.

In this embodiment of the present invention, a solder alloy is selected and used as the substrate. The solder alloy is a solder alloy with a low melting point, for example, an indium-based alloy or a gallium-based alloy. The substrate made of the solder alloy has a thickness of 10 to 50 µm. The solder alloy has a first surface and a second surface, on both of which the nano carbon material is disposed. The nano carbon material disposed on the first surface of the substrate has a length of 0.5 to 10 µm, and the nano carbon material disposed on the second surface of the substrate has a length of 50 to 150 µm.

In order to increase mechanical strength of the thermal interface pad with the solder alloy used as the substrate, the thermal interface pad further includes a vapor deposited layer or a sputtered layer. The nano carbon material on the second surface of the substrate penetrates, in a direction away from the substrate, through the vapor deposited layer or the sputtered layer, and a portion penetrating through the vapor deposited layer or the sputtered layer is 0.5-10 µm long. Further preferably, a total cross-sectional area of the nano carbon material penetrating through the vapor deposited layer or the sputtered layer accounts for 50% to 99% of an area of the second surface of the substrate.

In the thermal interface pad provided in this embodiment of the present invention, both the substrate and the nano carbon material have high thermal conductivity, and the nano carbon material may fill the micropores microscopically existing in the surface of the heat emitting component or the surface of the heat dissipating component, thereby significantly reducing the thermal contact resistance. In addition, the thermal interface pad provided in this embodiment of the present invention has a substrate structure, may be attachable and affixed, and is easy for industrial production and use, thereby addressing a problem of a thermal interface pad being unable to simultaneously satisfy requirements of high thermal conductivity and easy industrial production and use in the prior art.

A first example not covered by the present invention provides a production method of a thermal interface pad, including the following steps:

Fasten a substrate by using a clamp in a reaction chamber, heat the reaction chamber to 700 to 1200°C in an atmosphere of a protective gas, and then introduce a carbon source gas and keep reaction for 2 to 20 minutes at a constant temperature, where the substrate is a flexible composite metal film or flexible graphite, the substrate has a first surface and a second surface opposite to the first surface, both the first surface and the second surface of the substrate are loaded with a catalyst, and the flexible composite metal film is a flexible metal film with a surface coated with nickel, silver or gold.

Cool to room temperature in the atmosphere of the protective gas after the reaction is complete, so as to produce a substrate with a nano carbon material grown on both the first surface and the second surface, that is, to produce the thermal interface pad, where the nano carbon material is carbon nanowires arranged in an array.

The flexible composite metal film is a flexible metal film with a surface coated with nickel, silver or gold. The production method thereof is that a metal such as nickel, silver or gold is disposed on the surface of the flexible metal film by means of conventional electroplating, chemical plating, vapor deposition or sputtering. Particles of the catalyst have a particle size of 50 to 200 nm.

To facilitate growth of the nano carbon material, a catalyst may be loaded on the surface of the flexible composite metal film or the flexible graphite. A method for loading the catalyst is the same as that in a conventional technology. For example, a carrier to be coated, that is, the flexible composite metal film or the flexible graphite, is soaked in a nickel nitrate solution with a concentration ranging from 0.01 mol/L to 0.05 mol/L for 20s to 40s. Then the soaked substrate is dried in a vacuum dry box at 80 to 100°C for 1 to 4 hours, and then taken out and placed in a quartz boat. The substrate is heated to 200 to 400°C at a rate of 10-20°C/min in a constant-temperature zone of a quartz reaction tube in an atmosphere of a protective gas, and calcinated at the constant temperature for 1 to 4 hours.

The protective gas is generally one of nitrogen and argon, or a combination thereof. The carbon source gas is one or more of methane, ethylene, propylene, acetylene, methanol, and ethanol.

The reaction chamber is heated to 700 to 900°C in the atmosphere of the protective gas. Then the carbon source gas is introduced and the reaction is kept at the constant temperature for 3 to 10 minutes.

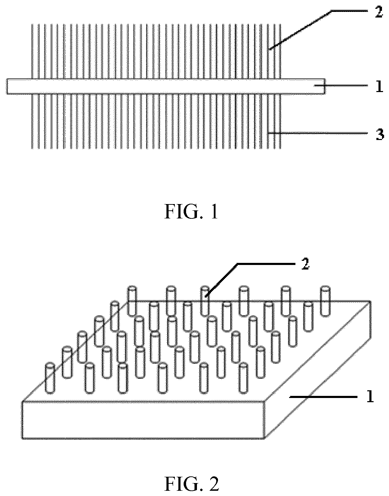

FIG. 1 is a side view of a thermal interface pad produced by using a production method according to the first example of FIG. 2 is a three-dimensional view of a part of a thermal interface pad produced by using a production method according to the first example. As shown in FIG. 1 and FIG. 2, the thermal interface pad includes a substrate and a nano carbon material. The substrate has a first surface and a second surface opposite to the first surface. The nano carbon material is disposed on both the first surface and the second surface of the substrate, and the nano carbon material is carbon nanowires arranged in an array. The substrate is one of a flexible composite metal film and flexible graphite. The flexible composite metal film is a flexible metal film with a surface coated with nickel, silver or gold.

The carbon nanowires are perpendicular to at least one surface of the first surface and the second surface of the substrate.

The carbon nanowires are at least one of carbon nanofibers and multi-walled carbon nanotubes.

The carbon nanofibers have a diameter of 50 to 200 nm.

The multi-walled carbon nanotubes have a diameter of 1 to 50 nm.

The flexible metal film is one of copper foil, aluminum foil, nickel foil, a copper alloy sheet, and a stainless steel sheet.

The flexible composite metal film has a thickness of 10 to 200 µm.

The flexible graphite is highly oriented pyrolytic graphite.

The flexible graphite has a thickness of 10 to 200 µm.

The nano carbon material disposed on at least one surface of the first surface and the second surface of the substrate has a length of 20 to 125 µm.

The first example provides a production method of a thermal interface pad, which addresses a problem of direct reaction of a chemically reactive flexible metal film and a catalyst affecting the growth of the nano carbon material. In addition, compared with production of a carbon nanotube array, this method has advantages of simple devices in use, a large production volume, low costs, and easy control of product quality. The produced thermal interface pad not only has high thermal conductivity, but may be attachable and affixed, and therefore is easy for industrial production and use.

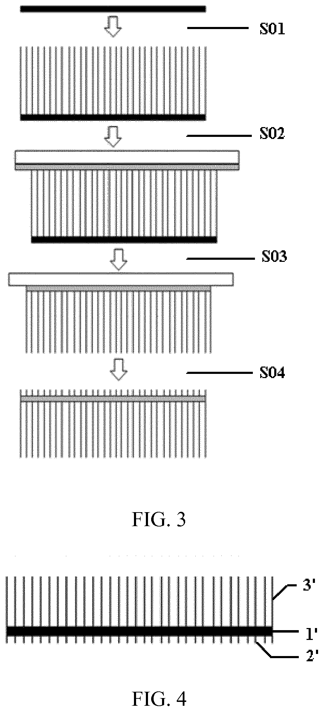

An embodiment covered by the present invention provides a production method of a thermal interface pad. FIG. 3 is a flowchart of the production method according to this embodiment of the present invention. As shown in FIG. 3, the method includes the following steps:
(1) Grow a nano carbon material on a first surface of a silicon base plate or a quartz base plate by means of chemical vapor deposition, where the nano carbon material is carbon nanowires arranged in an array, as shown in step S01.
(2) Dispose copper foil on a solder alloy on a pressed surface of an end, which is away from the first surface of the silicon base plate or the quartz base plate, of the grown nano carbon material, with the solder alloy being in contact with the nano carbon material, as shown in step S02; perform heating until a temperature is higher than a melting point of the solder alloy to melt the solder alloy, and then cool the solder alloy; and mechanically peel the silicon base plate or the quartz base plate from the nano carbon material, as shown in step S03, so as to produce a solder alloy substrate composite material, where the solder alloy composite material includes the nano carbon material, the solder alloy coated on the surface of the end of the nano carbon material, and the copper foil attached to the end of the nano carbon material.
(3) Soak the solder alloy substrate composite material in an acid solution to dissolve the copper foil, so as to produce a solder alloy substrate excluding the copper foil, which is washed and then dried, where the solder alloy remains on one end of the nano carbon material in the solder alloy substrate; heat the solder alloy substrate to a temperature above the melting point of the solder alloy, so that the solder alloy is melted and the solder alloy in a melting state moves towards the other end of the nano carbon material; and cool the solder alloy substrate, as shown in step S04, to produce the thermal interface pad, where the thermal interface pad has the solder alloy as a substrate, the substrate has a first surface and a second surface opposite to the first surface, the nano carbon material is disposed on both the first surface and the second surface of the substrate, and the nano carbon material is carbon nanowires arranged in an array.

In step (1), the prior art is applied to the growth of the nano carbon material arranged in an array on the first surface of the silicon base plate or the quartz base plate by means of chemical vapor deposition. The silicon base plate and the quartz base plate have a low thermal expansion coefficient, and are chemically inactive, which help improve quality of the nano carbon material, and can be easily controlled. Preferably, a condition for the chemical vapor deposition in step (1) is that a thermal chemical vapor deposition apparatus is used, into which carbon source and protective gases are introduced, and the chemical reaction takes place at 700 to 1200°C and lasts for 3 to 10 minutes. Accordingly, a height of the nano carbon material produced in step (1) ranges from 50.5 µm to 160 µm.

In step (2), when the solder alloy is melted by heating, the nano carbon material soaks up the solder alloy by means of forces of capillary attraction, and firmly bonds to the solder alloy after the cooling. An interface bonding force between the nano carbon material and the solder alloy is greater than that between the nano carbon material and the silicon base plate or the quartz base plate. Therefore, the nano carbon material may be mechanically peeled from the silicon base plate or the quartz base plate.

To facilitate the mechanical peeling, nickel, gold or a tin-based solder alloy may be vapor deposited or sputtered on a surface of carbon nanofibers before step (2), so as to form a vapor deposited layer or a sputtered layer. The vapor deposition or sputtering is a metallization process, which is used to increase mechanical strength of the nano carbon material.

In step (3), the solder alloy substrate is heated to a temperature above the melting point of the solder alloy, so that the solder alloy is melted and the solder alloy in the melting state moves towards the other end of the nano carbon material. It may be understood that one end of the carbon nanofiber array is exposed from a first surface of the solder alloy by means of forces of capillary attraction.

The carbon nanowires are perpendicular to at least one surface of the first surface and the second surface of the substrate.

The carbon nanowires are at least one of the carbon nanofibers and multi-walled carbon nanotubes.

The carbon nanofibers have a diameter of 50 to 200 nm.

The multi-walled carbon nanotubes have a diameter of 1 to 50 nm.

FIG. 4 is a side view of a thermal interface pad produced by using a production method according to an embodiment of the present invention. As shown in FIG. 4, the thermal interface pad includes a substrate and a nano carbon material. The substrate has a first surface and a second surface opposite to the first surface. The nano carbon material is disposed on both the first surface and the second surface of the substrate, and the nano carbon material is carbon nanowires arranged in an array. The substrate is made from a solder alloy.

An indium-based alloy or a gallium-based alloy is selected as the solder alloy. More preferably, the substrate made from the solder alloy has a thickness of 10 to 50 µm, and more preferably, the carbon nanowires disposed on the first surface of the substrate have a length of 0.5 to 10 µm, and the carbon nanowires disposed on the second surface of the substrate have a length of 50 to 150 µm.

In order to increase mechanical strength of the nano carbon material, further preferably, nickel, gold or a tin-based solder alloy is vapor deposited or sputtered on a surface of the nano carbon material on the second surface of the substrate after step (3), so as to form a vapor deposited layer or a sputtered layer. The nano carbon material on the second surface of the substrate penetrates, in a direction away from the substrate, through the vapor deposited layer or the sputtered layer, and a portion penetrating through the vapor deposited layer or the sputtered layer is 0.5-10 µm long. A total cross-sectional area of the nano carbon material penetrating through the vapor deposited layer or the sputtered layer accounts for 50% to 99% of an area of the second surface of the substrate.

According to the production method of a thermal interface pad provided by the first embodiment of the present invention, the well-grown nano carbon material is transferred from a silicon base plate or a quartz base plate to the solder alloy substrate, and exposed from the first surface of the substrate by using a particular process, so that the nano carbon material is disposed on both the first surface and the second surface of the substrate. The produced thermal interface pad not only has high thermal conductivity, but may be attachable and affixed, and therefore is easy for industrial production and use.

### Example 1

A production method of a thermal interface pad includes the following steps:
(1) Pretreatment of a flexible composite metal film: Following a conventional electroplating method, plate metal nickel on a surface of electrolytic copper foil (it may be required that corresponding inert coating treatment should be done before a material is supplied by a copper foil manufacturer), so as to produce electrolytic copper foil that is 12 µm thick and has a surface plated with nickel, which is a flexible composite metal film. Ultrasonically wash the flexible composite metal film separately by using deionized water and acetone, dry the flexible composite metal film, and then perform argon plasma treatment for lmin. Mix nickel nitrate with deionized water to form a nickel nitrate solution of 0.02 mol/L, soak the flexible composite metal film to be deposited in the nickel nitrate solution for 30s, dry the soaked flexible composite metal film in a vacuum dry box at 90°C for 2 hours, then take out and place the flexible composite metal film in a quartz boat. Heat the flexible composite metal film to 300°C at a rate of 20°C/min in a constant-temperature zone of a quartz reaction tube under protection of argon, and calcinate the flexible composite metal film at the constant temperature for 1 hour, so as to produce a flexible composite metal film loaded with a catalyst.
(2) Place the flexible composite metal film produced in step (1), as a substrate, in a quartz clamp, and place the quartz clamp in the constant-temperature zone of the quartz reaction tube, where the substrate has a first surface and a second surface opposite to the first surface, both the first surface and the second surface of the substrate are loaded with a catalyst, and a gas may flow through the first surface and the second surface. Heat a reaction chamber to 900°C at a rate of 20°C/min in an argon atmosphere, and introduce a mixture of argon, hydrogen, and acetylene, where flow rates of the three gases are 200 mL/min, 80 mL/min, and 60 mL/min respectively. Keep reaction at the constant temperature of 900°C for 10 minutes. After the reaction is complete, rapidly lower a furnace temperature to room temperature in the argon atmosphere, so as to produce a substrate with a nano carbon material grown on both the first surface and the second surface, that is, to produce a thermal interface pad, where the nano carbon material is carbon nanowires arranged in an array.

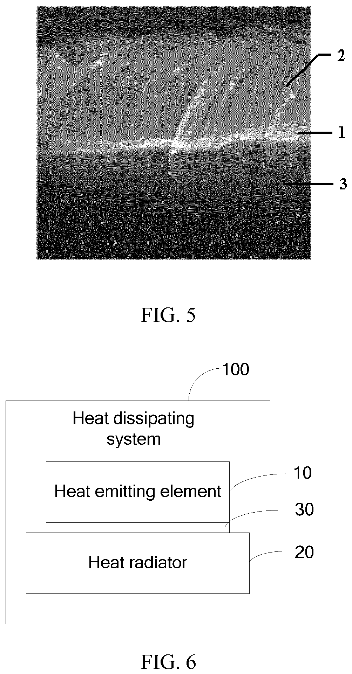

FIG. 5 is an SEM (scanning electronic microscope) image of a thermal interface pad produced by using the production method according to Example 1. As shown in FIG. 5, the thermal interface pad produced according to Example 1 of the present invention includes a substrate and a nano carbon material. The substrate is a flexible composite metal film, which has a first surface and a second surface opposite to the first surface. The nano carbon material is disposed on both the first surface and the second surface of the substrate, and the nano carbon material is carbon nanowires arranged in an array. The substrate has a thickness of 12 µm, and the nano carbon material disposed on the first surface and the second surface of the substrate has a height of approximately 60 µm.

### Example 2

A production method of a thermal interface pad includes the following steps:

Use flexible graphite, which is preferably highly oriented pyrolytic graphite (PGS graphite film from Panasonic), as a substrate, where the substrate has a first surface and a second surface opposite to the first surface. Place the PGS graphite film from Panasonic in a tube-type resistance furnace, and perform heating to a reaction temperature of approximately 850°C under protection of argon. Then, introduce hydrogen and argon at a flow rate of 300 sccm and 1000 sccm respectively, and meanwhile, continuously feed a xylene solution that has a concentration of 0.025 g/ml and is dissolved with ferrocene to a reaction chamber at a controlled flow rate of 0.4 mL/min. By virtue of transportation of the hydrogen and argon, the ferrocene and xylene reach the PGS graphite film, and Fe atomic clusters generated from decomposition of the ferrocene are loaded on a first surface and a second surface of the PGS graphite film. With the help of catalysis of the Fe atomic clusters, carbon atoms generated from pyrolysis of the xylene form carbon nanofibers. Keep reaction at a constant temperature for 6 minutes. After the reaction is complete, cool the PGS graphite film to room temperature in an atmosphere of a protective gas, so as to produce a PGS graphite film with a nano carbon material grown on both the first surface and the second surface, that is, to produce a thermal interface pad. The nano carbon material is carbon nanowires arranged in an array, and the nano carbon material disposed on the first surface and the second surface of the substrate has a height of approximately 50 µm.

### Embodiment 1

A production method of a thermal interface pad includes the following steps:
(1) Chemical vapor deposition: Place a silicon base plate in a reaction chamber into which acetylene is introduced. Raise a temperature of the reaction chamber to 700°C. A nano carbon material is grown on a first surface of the silicon base plate, where the nano carbon material is carbon nanowires arranged in an array. The produced carbon nanowires include a large number of carbon nanofibers with a diameter of 50 to 90 nm and a small number of multi-walled carbon nanotubes with a diameter of 30 to 50 nm. The nano carbon material is approximately 150 µm high.
(2) Dispose copper foil of an indium-based solder alloy Sn42In58 on a pressed surface of an end, which is away from the first surface of the silicon base plate, of the grown nano carbon material, with the indium-based solder alloy being in contact with the nano carbon material. Perform heating to a temperature above 118°C to melt the indium-based solder alloy, and then perform cooling. Mechanically peel the silicon base plate from the nano carbon material, so as to produce an indium-based solder alloy substrate composite material. The indium-based solder alloy substrate composite material includes the nano carbon material, the solder alloy coated on the surface of the end, which is away from the first surface of the silicon base plate, of the nano carbon material, and the copper foil attached to the end, which is away from the first surface of the silicon base plate, of the nano carbon material.
(3) Soak the solder alloy substrate composite material in an acid solution to dissolve the copper foil, so as to produce a solder alloy substrate excluding the copper foil, which is washed and then dried. The solder alloy remains on one end of the nano carbon material in the solder alloy substrate. Heat the solder alloy substrate to a temperature above a melting point 118°C of the solder alloy, so that the solder alloy is melted and the solder alloy in a melting state moves towards the other end of the nano carbon material. Perform cooling to produce a thermal interface pad. The thermal interface pad uses the solder alloy that is 10 µm thick as a substrate, and the substrate has a first surface and a second surface opposite to the first surface. The nano carbon material is disposed on both the first surface and the second surface of the substrate. The nano carbon material disposed on the first surface of the substrate has a height of approximately 1 to 2 µm, and the nano carbon material disposed on the second surface of the substrate has a height of approximately 140 µm. The nano carbon material is carbon nanowires arranged in an array.

### Embodiment 2

A production method of a thermal interface pad includes the following steps:
(1) Chemical vapor deposition: Place a silicon base plate in a reaction chamber into which acetylene is introduced. Raise a temperature of the reaction chamber to 700°C. A nano carbon material is grown on a first surface of the silicon base plate, where the nano carbon material is carbon nanowires arranged in an array. The produced carbon nanowires include a large number of carbon nanofibers with a diameter of 50 to 90 nm and a small number of multi-walled carbon nanotubes with a diameter of 30 to 50 nm. The nano carbon material is approximately 150 µm high. Before step (2), use a vacuum vapor deposition apparatus to deposit flimsy gold on a surface of the nano carbon material, where the gold layer is approximately 0.2 µm thick, so as to increase mechanical strength and electrical conductivity of the nano carbon material.
(2) Dispose copper foil of an indium/tin-based solder alloy In97Ag3 on a pressed surface of an end, which is away from the first surface of the silicon base plate, of the grown nano carbon material, with the In97Ag3 solder alloy being in contact with the nano carbon material. Perform heating to a temperature above a melting point 143°C of the In97Ag3 to melt the In97Ag3 solder alloy, and then perform cooling. Mechanically peel the silicon base plate from the nano carbon material, so as to produce an indium/tin-based solder alloy substrate composite material. The indium/tin-based solder alloy substrate composite material includes the nano carbon material, the solder alloy coated on the surface of the end, which is away from the first surface of the silicon base plate, of the nano carbon material, and the copper foil attached to the end, which is away from the first surface of the silicon base plate, of the nano carbon material.
(3) Soak the solder alloy substrate composite material in an acid solution to dissolve the copper foil, so as to produce a solder alloy substrate excluding the copper foil, which is washed and then dried. The solder alloy remains on one end of the nano carbon material in the solder alloy substrate. Heat the solder alloy substrate to a temperature above the melting point of the solder alloy, so that the solder alloy is melted and the solder alloy in a melting state moves towards the other end of the nano carbon material. Perform cooling, and use a magnetron sputtering apparatus to sputter Au, Ag, Ni, or Pt on the surface of the nano carbon material on a second surface of the substrate. A thickness of a sputtered layer preferably ranges from 0.5 µm to 1 µm. The sputtered nano carbon material has an end of 2-3 µm high exposed outside a vapor deposited layer, and an exposed area of the end is 90%-95% of an area of the vapor deposited layer. In this way, a thermal interface pad is produced. The thermal interface pad uses the solder alloy that is 10 µm thick as a substrate, and the substrate has a first surface and a second surface opposite to the first surface. The nano carbon material is disposed on both the first surface and the second surface of the substrate. The nano carbon material disposed on the first surface of the substrate has a height of approximately 1 to 2 µm, and the nano carbon material disposed on the second surface of the substrate has a height of approximately 140 µm. The nano carbon material is carbon nanowires arranged in an array.

Referring to FIG. 6, an embodiment of the present invention provides a heat dissipating system 100. The heat dissipating system 100 includes a heat emitting element 10, a heat radiator 20, and a thermal pad 30. The thermal pad 30 is made of a thermal interface pad. The thermal pad 30 is closely affixed between the heat emitting element 10 and the heat radiator 20, so that the heat emitting element 10 transfers heat through the thermal pad 30 to the heat radiator 20 for heat dissipation.

In this embodiment, the heat dissipating system includes the heat emitting element 10, the heat radiator 20, and the thermal pad 30. The thermal pad 30 is made of the thermal interface pad. The thermal pad 30 is closely affixed between the heat emitting element 10 and the heat radiator 20, so that the heat emitting element 10 transfers heat through the thermal pad 30 to the heat radiator 20 for heat dissipation. As an independent element, the thermal pad 30 may be attachable and affixed between the heat emitting element 10 and the heat radiator 20, thereby facilitating mounting. In addition, the thermal pad 30 is made of the thermal interface pad. Nano carbon materials 2 and 3 are disposed on both sides of a substrate 1 of the thermal interface pad, and carbon fibers in the nano carbon materials 2 and 3 have a nano-scale diameter. The nano carbon material may fill micropores (generally represented by roughness, on a micron scale) existing in the bottom of the heat emitting element 10 or in the top surface of the heat radiator 20, thereby significantly reducing thermal contact resistance of the thermal pad 30. Moreover, the nano carbon materials 2 and 3 are axially perpendicular to a first surface and/or a second surface of the substrate 1. Ordered arrangement of carbon nanofibers enables the carbon nanofibers to have a uniform and better thermal conductivity in a thickness direction. Theoretically, the nano carbon material can have a thermal conductivity in an axial direction (Z direction) of 2000 w/(m·k), and an electrical resistivity of 5×10⁻⁵ ohmcm, thereby greatly improving a heat transfer effect between the heat emitting element 10 and the heat radiator 20.

### Effect Example

The thermal interface pad produced in Example 1 is placed between a heat source and a heat radiator. By means of pressure and thickness control of homemade tooling, a thickness of the foregoing material is compressed from 0.13 mm before assembly to 0.05 mm. An overall thermal resistance of this material is tested to be approximately 16°C-mm²/W, which is lower than a thermal resistance of approximately 24°C-mm²/W of a tin-lead solder in a same test condition, and is lower than a thermal resistance of approximately 40°C-mm²/W of CF3350 in a same test condition. It indicates that this material has a thermal resistance lower than that of a solder when the material is applied as a TIM. This material has electrical conductivity that is slightly inferior to the tin-lead solder, a volume resistivity of approximately 10⁻⁴ ohm-cm, and fully satisfactory ground impedance. Using this material, heat dissipation of a high power density device may be achieved, a heat dissipation effect comparable to that of a welding material may be attained, and weldable coating treatment for a heat dissipating component may be avoided, thereby significantly reducing costs. In addition, a thermal interface pad provided in an embodiment of the present invention has a substrate structure, may exist independently of a heat emitting element and a heat dissipating device, may be attachable and affixed, and therefore is easy for industrial production and use, thereby addressing a problem of a thermal interface material being unable to simultaneously satisfy requirements of high thermal conductivity and easy industrial production and use in the prior art.

## Claims

1. A thermal interface pad, comprising a substrate (1) and carbon nanowires, wherein the substrate (1) has a first surface and a second surface opposite to the first surface, the carbon nanowires are disposed on both the first surface and the second surface of the substrate (1), and the carbon nanowires are arranged in an array, **characterized in that** the substrate (1) is made from a solder alloy and has a thickness of 10 to50 µm,
wherein the carbon nanowires disposed on the first surface of the substrate (1) have a length of 0.5 to 10 µm,and the carbon nanowires disposed on the second surface of the substrate (1) have a length of 50 to 150 µm, and
wherein the thermal interface pad further comprises a vapor deposited layer or a sputtered layer, the vapor deposited layer or the sputtered layer is located on one side of the second surface of the substrate (1), the carbon nanowires located on the second surface penetrate into the vapor deposited layer or the sputtered layer, at least one portion of the carbon nanowires on the second surface penetrates through the vapor deposited layer or the sputtered layer, and projects out of the vapor deposited layer or the sputtered layer, and the portion of the carbon nanowires projecting out of the vapor deposited layer or the sputtered layer has a length of 0.5 to 10 µm.

2. The thermal interface pad according to claim 1, wherein the carbon nanowires are perpendicular to at least one surface of the first surface and the second surface of the substrate (1).

3. The thermal interface pad according to claim 1 or 2, wherein the carbon nanowires comprise carbon nanofibers, or multi-walled carbon nanotubes, or both.

4. The thermal interface pad according to claim 3, wherein the carbon nanofibers have a diameter of 50 to 200 nm.

5. The thermal interface pad according to claim 3, wherein the multi-walled carbon nanotubes have a diameter of 1 to 50 nm.

6. The thermal interface pad according to claim 1, wherein the solder alloy is an indium-based alloy or a gallium-based alloy.

7. A heat dissipating system (100), comprising a heat emitting element (10), a heat radiator (20), and a thermal pad (30), wherein the thermal pad comprises the thermal interface pad according to claim 1 or 2, the heat emitting element (10) is located on one side of the heat radiator (20), and the thermal pad (30) is affixed between the heat emitting element (10) and the heat radiator (20), so that the heat emitting element (10) transfers heat through the thermal pad (30) to the heat radiator (20) for heat dissipation.

## Patentansprüche

1. Wärmeschnittstellenpad, das ein Substrat (1) und Kohlenstoffnanodrähte umfasst, wobei das Substrat (1) eine erste Oberfläche und eine zweite Oberfläche gegenüber der ersten Oberfläche aufweist, die Kohlenstoffnanodrähte auf sowohl der ersten Oberfläche als auch der zweiten Oberfläche des Substrats (1) angeordnet sind und die Kohlenstoffnanodrähte in einem Array angeordnet sind, **dadurch gekennzeichnet, dass** das Substrat (1) aus einer Lötlegierung gefertigt ist und eine Dicke von 10 bis 50 µm aufweist,
wobei die Kohlenstoffnanodrähte, die auf der ersten Oberfläche des Substrats (1) angeordnet sind, eine Länge von 0,5 bis 10 µm aufweisen und die Kohlenstoffnanodrähte, die auf der zweiten Oberfläche des Substrats (1) angeordnet sind, eine Länge von 50 bis 150 µm aufweisen, und
wobei das Wärmeschnittstellenpad ferner eine aufgedampfte Schicht oder eine aufgesputterte Schicht umfasst, wobei sich die aufgedampfte Schicht oder die aufgesputterte Schicht auf einer Seite der zweiten Oberfläche des Substrats (1) befindet, sich die Kohlenstoffnanodrähte, die sich auf der zweiten Oberfläche befinden, in die aufgedampfte Schicht oder die aufgesputterte Schicht eindringen, wenigstens ein Teil der Kohlenstoffnanodrähte auf der zweiten Oberfläche die aufgedampfte Schicht oder die aufgesputterte Schicht durchdringt und aus der aufgedampften Schicht oder der aufgesputterten Schicht herausragt und der Teil der Kohlenstoffnanodrähte, der aus der aufgedampften Schicht oder der aufgesputterten Schicht herausragt, eine Länge von 0,5 bis 10 µm aufweist.

2. Wärmeschnittstellenpad nach Anspruch 1, wobei die Kohlenstoffnanodrähte senkrecht zu wenigstens einer Oberfläche der ersten Oberfläche und der zweiten Oberfläche des Substrats (1) sind.

3. Wärmeschnittstellenpad nach Anspruch 1 oder 2, wobei die Kohlenstoffnanodrähte Kohlenstoffnanofasern oder mehrwandige Kohlenstoffnanoröhrchen oder beides umfassen.

4. Wärmeschnittstellenpad nach Anspruch 3, wobei die Kohlenstoffnanofasern einen Durchmesser von 50 bis 200 nm aufweisen.

5. Wärmeschnittstellenpad nach Anspruch 3, wobei die mehrwandigen Kohlenstoffnanoröhrchen einen Durchmesser von 1 bis 50 nm aufweisen.

6. Wärmeschnittstellenpad nach Anspruch 1, wobei die Lötlegierung eine indiumbasierte Legierung oder eine galliumbasierte Legierung ist.

7. Wärmedissipationssystem (100), das ein wärmeemittierendes Element (10), einen Wärmeradiator (20) und ein Wärmepad (30) umfasst, wobei das Wärmepad das Wärmeschnittstellenpad nach Anspruch 1 oder 2 umfasst, sich das wärmeemittierende Element (10) auf einer Seite des Wärmeradiators (20) befindet und das Wärmepad (30) zwischen dem wärmeemittierenden Element (10) und dem Wärmeradiator (20) befindet, so dass das wärmeemittierende Element (10) durch das Wärmepad (30) Wärme an den Wärmeradiator (20) zur Wärmedissipation transferiert.

## Revendications

1. Tampon d'interface thermique, comprenant un substrat (1) et des nanofils de carbone, le substrat (1) ayant une première surface et une deuxième surface à l'opposé de la première surface, les nanofils de carbone étant disposés à la fois sur la première surface et la deuxième surface du substrat (1), et les nanofils de carbone étant agencés en un réseau, **caractérisé en ce que** le substrat (1) est constitué d'un alliage à braser et a une épaisseur de 10 à 50 µm,
les nanofils de carbone disposés sur la première surface du substrat (1) ayant une longueur de 0,5 à 10 µm,et les nanofils de carbone disposés sur la deuxième surface du substrat (1) ayant une longueur de 50 à 150 µm,et
le tampon d'interface thermique comprenant en outre une couche déposée en phase vapeur ou une couche pulvérisée, la couche déposée en phase vapeur ou la couche pulvérisée étant située sur un côté de la deuxième surface du substrat (1), les nanofils de carbone situés sur la deuxième surface pénétrant dans la couche déposée en phase vapeur ou la couche pulvérisée, au moins une partie des nanofils de carbone sur la deuxième surface pénétrant à travers la couche déposée en phase vapeur ou la couche pulvérisée, et faisant saillie hors de la couche déposée en phase vapeur ou de la couche pulvérisée, et la partie des nanofils de carbone faisant saillie hors de la couche déposée en phase vapeur ou de la couche pulvérisée ayant une longueur de 0,5 à 10 µm.

2. Tampon d'interface thermique selon la revendication 1, dans lequel les nanofils de carbones sont perpendiculaires à au moins une surface parmi la première surface et la deuxième surface du substrat (1).

3. Tampon d'interface thermique selon la revendication 1 ou 2, dans lequel les nanofils de carbone comprennent des nanofibres de carbone, ou des nanotubes de carbone multiparois, ou les deux.

4. Tampon d'interface thermique selon la revendication 3, dans lequel les nanofibres de carbone ont un diamètre de 50 à 200 nm.

5. Tampon d'interface thermique selon la revendication 3, dans lequel les nanotubes de carbone multiparois ont un diamètre de 1 à 50 nm.

6. Tampon d'interface thermique selon la revendication 1, dans lequel l'alliage à braser est un alliage à base d'indium ou un alliage à base de gallium.

7. Système de dissipation thermique (100), comprenant un élément émettant de la chaleur (10), un élément rayonnant la chaleur (20), et un tampon thermique (30), le tampon thermique comprenant le tampon d'interface thermique selon la revendication 1 ou 2, l'élément émettant de la chaleur (10) étant situé sur un côté de l'élément rayonnant la chaleur (20), et le tampon thermique (30) étant fixé à l'élément émettant de la chaleur (10) et à l'élément rayonnant la chaleur (20), de telle sorte que l'élément émettant de la chaleur (10) transfère de la chaleur à travers le tampon thermique (30) à l'élément rayonnant la chaleur (20) pour dissipation thermique.
